# EUROPEAN PATENT SPECIFICATION

(11) **EP 0 771 138 B1**
(45) Date of publication and mention of the grant of the patent: **07.04.1999**
(21) Application number: 96402281.8
(22) Date of filing: 25.10.1996
(51) Int. Cl.: H05K 7/20, H01L 23/427

(54) **Cooling device for electric components in a casing of a travelling structure**
Kühlungsvorrichtung für eine elektrische Baugruppe in einer fahrbaren Struktur
Dispositif de refroidissement de composants électriques d'un boîtier d'une structure de transport

(30) Priority: 26.10.1995 JP 278596/95
(43) Date of publication of application: 02.05.1997
(73) Proprietor: THE FURUKAWA ELECTRIC CO., LTD., Tokyo (JP)
(72) Inventor: Murase, Takashi c/o The Furukawa Elect. Co. Ltd., Chiyoda-ku, Tokyo (JP); Takahashi, Takeshi c/o The Furukawa Elect. Co. Ltd, Chiyoda-ku, Tokyo (JP); Kawano, Kazuhiro c/o The Furukawa Elect. Co. Ltd., Chiyoda-ku, Tokyo (JP); Tsukada, Isao c/o The Furukawa Elect. Co. Ltd., Chiyoda-ku, Tokyo (JP)
(74) Representative: Jacobson, Claude

(56) References cited:
- EP-A- 0 577 099
- AU-B- 520 046
- FR-A- 2 334 525
- PATENT ABSTRACTS OF JAPAN vol. 17, no. 687 (E-1478), 16 December 1993 & JP 05 235224 A (TOSHIBA TORANSUPOOTO ENG KK), 10 September 1993,
- PATENT ABSTRACTS OF JAPAN vol. 7, no. 65 (E-165) [1210] , 18 March 1983 & JP 57 211260 A (MATSUSHITA DENKI SANGYO K.K.), 25 December 1982,
- PATENT ABSTRACTS OF JAPAN vol. 7, no. 65 (E-165) [1210] , 10 March 1983 & JP 57 211256 A (TOYO DENKI SEIZO K.K.), 25 December 1982,

## Description

This invention generally relates to a cooling device for electric components installed in an electric-power control casing of a travelling structure such as vehicles, airplanes and ships, and more particularly, to a cooling device which is suitable for cooling electric components installed in the casing by utilizing an air current produced when the travelling structure travels, and enables to cool the electric components even when the travelling structure is in the stopped state.

From EP-A-577099 there is for example known a cooling apparatus for electronic elements.

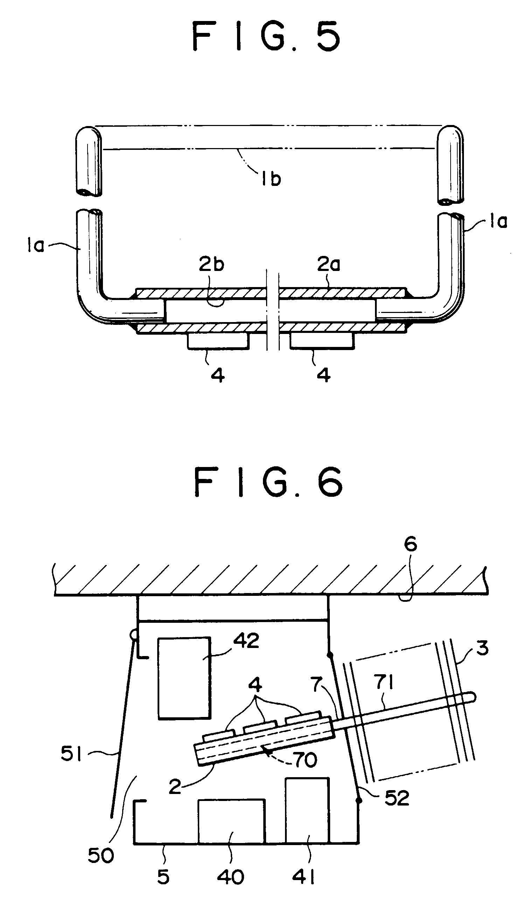

A description will now be given of a cooling device in a prior art for electric components installed in an air-tightly sealed casing of a vehicle such as a train with reference to Fig. 6.

An electric-power control casing 5 is fixed to the undersurface 6 of a floor of a vehicle such as a train, and is isolated from the outside. The casing 5 contains electric components such as a snubber resistance 40, a snubber capacitor 41 and a gate amplifier 42.

One side wall of the casing 5 has an opening 50 closed by an openable/closable cover 51. The casing 5 is structured such that the inspection and maintenance of the inside of the casing 5 are performed by opening the cover 51, if necessary.

The other side wall of the casing 5 has an inclined partition plate 52. A plurality of straight heat pipes 7 are pierced through the partition plate 52 and held at substantially right angles with the partition plate 52. Each heat pipe 7 is inclined at an angle of about 7° such that the leading end of a heating section 70 of each heat pipe extends downward.

The heating section 70 of each heat pipe 7 is located inside the casing 5, and mounted with a heat absorbing block 2 on its top or bottom surface. The heat absorbing block 2 is mounted with heat-generating electric components 4 such as semiconductor modules through screws (not shown).

A heat radiative section 71 of each heat pipe 7 is projected from the casing 5 outward, and mounted with a large number of radiation fins 3.

Normally, the vehicle travels (toward this side or in the opposite direction in the drawing) such that an air current produced in consequence of its traveling flows along the radiation fins 3.

According to the cooling device described above, heat generated by the electric components 4 and heat generated in the casing 5 by the snubber resistance 40, the snubber capacitor 41 and the gate amplifier 42 are conducted to the heating section 70 of each heat pipe 7 through the heat absorbing block 2, then transported to the heat radiative section 71 due to the evaporation of a working fluid enclosed in each heat pipe 7, and consequently radiated through the radiation fins 3 to the outside.

The cooling device in the prior art structured as described above has the following drawbacks.

One of the drawbacks is that since the heating section 70 of each heat pipe 7 is largely projected into the casing 5, the spatial utility factor in the casing 5 is degraded, and as a result, the casing 5 needs to have a larger capacity in order to mount required components such as the snubber resistance 40, the snubber capacitor 41 and the gate amplifier 42 on the inside of the casing 5.

Another drawback is that the partition plate 52 needs to structurally bear a considerable part of the load applied to a heat-pipe piercing portion of the partition plate 52, and as a result, is weak in structure.

A further drawback is that since the electric components 4 are located on the upper or bottom surface of the heat absorbing block 2, the workability in case of performing the inspection and maintenance of the inside of the casing 5 by opening the cover 51 is degraded.

It is an object of the present invention to provide a cooling device for electric components installed in a casing of a travelling structure, whereby an improvement of the spatial utility factor in the casing is attained, any partition plate is not needed, and the workability in case of performing the inspection and maintenance of the inside of the casing is enhanced.

The cooling device according to the present invention as claimed has the following structure in order to overcome the above problems.

Namely, an electric component cooling device as a first aspect of the present invention comprises looped heat pipes 1 each having one substantially horizontal side which forms a heating section 10, or substantially U-shaped heat pipes 1 each having a substantially horizontal lower portion which forms a heating section 10, a heat absorbing block 2 mounted on the heating section 10 of each heat pipe 1 and mounted with heat-generating electric components 4, and radiation fins 3 mounted on a heat radiative section 11 of each heat pipe 1 in substantially parallel to the heating section 10, wherein the heat absorbing block 2 is mounted on the side wall of a casing 5 with the electric components 4 faced to the inside of the casing 5, and constitutes a part of the side wall of the casing 5.

An electric component cooling device as a second aspect of the present invention according to the cooling device as the first aspect of the present invention is characterized in that the heating section 10 of each heat pipe 1 is embedded in the heat absorbing block 2.

An electric component cooling device as a third aspect of the present invention comprises a heat absorbing block 2a having an appropriate number of holes 2b each positioned so as to extend in the substantially horizontal direction when being in use, and mounted with heat-generating electric components 4, pipes 1a respectively having one ends air-tightly communicated with both ends of each hole 2b, and radiation fins 3 mounted on each pipe 1a, wherein the other ends of the respective pipes 1a are communicated with each other as one body or air-tightly sealed, an appropriate quantity of refrigerant is enclosed in an air-tightly sealed system composed of the holes 2b and each pipe 1a, and the heat absorbing block 2a is mounted on the side wall of a casing 5 with the electric components 4 faced to the inside of the casing 5, and constitutes a part of the side wall of the casing 5.

The cooling device as the first aspect of the present invention has the following effects, since the heat absorbing block 2 is mounted on the side wall 54 of the casing 5 and constitutes a part of the side wall 54.

One of the effects is that since any partition plate for holding each heat pipe 1 by piercing each heat pipe 1 through the partition plate is not needed, and any heat pipe 1 is not pierced through the side wall 54 of the casing 5, the casing 5 is structured more firmly.

Another effect is that since the heating section 10 of each heat pipe 1 is not projected into the casing 5, the spatial utility factor of the casing 5 is improved to make it possible to install more components in the casing 5, or to reduce the size of the casing 5.

A further effect is that since the other side wall of the casing 5 has an opening 50 and is mounted with an openable/closable cover 51 so that the electric components 4 mounted on the heat absorbing block 2 or the snubber resistance 40, the snubber capacitor 41 and the gate amplifier 42 installed inside the casing are easily observed when the cover 51 is opened, the workability in case of performing the inspection and maintenance is remarkably improved.

A still further effect is that in comparison with a case where the cooling device employs L-shaped heat pipes 1, the heat radiation space is relatively made wider, and the inclination of a working fluid a enclosed in the heating section 10 is reduced more greatly even when the heating section 10 of each heat pipe 1 is inclined due to the traveling position of the traveling structure. Therefore, the cooling capability is enhanced more highly.

Besides, since the cooling device of the present invention employs the U-shaped or looped heat pipes 1, the heat conduction characteristics and the maximum heat transportation characteristics are enhanced, and the cooling device is made more compact as a whole.

The cooling device as the second and third aspects of the present invention has the following effects, in addition to the effects similar to those of the cooling device as the first aspect of the present invention.

Namely, according to the cooling device as the second aspect of the present invention, since the heating section 10 of each heat pipe 1 is embedded in the heat absorbing block 2, heat is satisfactorily conducted between the heating section 10 and the heat absorbing block 2.

According to the cooling device as the third aspect of the present invention, since the heat absorbing block 2 forms the heating section of the air-tightly sealed system as it is, any problem does not arise as to contact thermal resistance between the heating section 10 and the heat absorbing block 2, in comparison with a structure that the heating section 10 of each heat pipe 1 is pierced through the heat absorbing block 2 and held thereto like the cooling device as the first aspect of the present invention. Thus, the heat exchange capability at a heating portion of the air-tightly sealed system is enhanced more highly.
Fig. 1 is a schematic sectional view showing a cooling device in a first embodiment of the present invention;
Fig. 2 is a fragmentary plan sectional view showing the cooling device of Fig. 1;
Fig. 3 is a fragmentary sectional view showing a cooling device in a second embodiment of the present invention;
Fig. 4 is a fragmentary front view showing a heating section of a heat pipe in the second embodiment of the present invention;
Fig. 5 is a fragmentary plan sectional view showing a cooling device in a third embodiment of the present invention; and
Fig. 6 is a schematic sectional view showing a prior art cooling device mounted on the undersurface of a floor of a train.

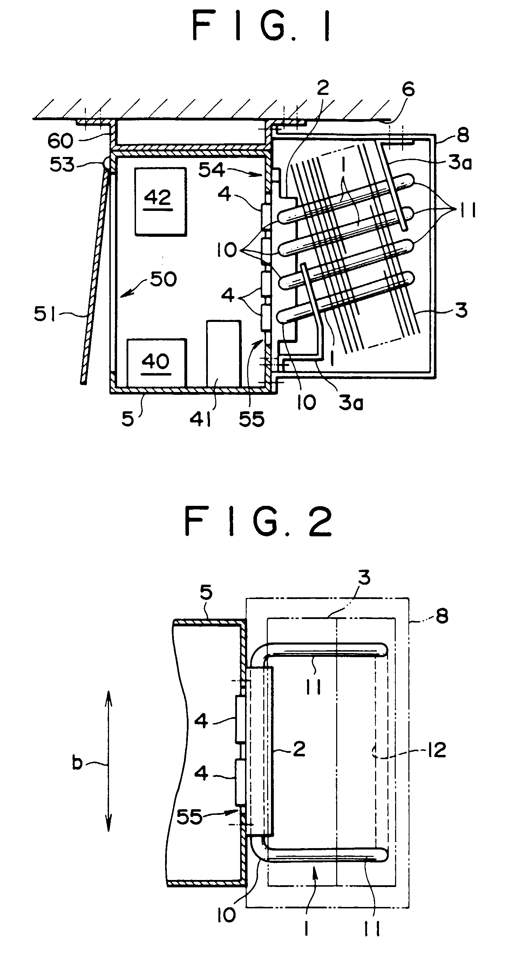

An electric component cooling device according to the present invention will now be described together with preferable embodiments with reference to Figs. 1 to 5.

Incidentally, portions or components similar to those of the prior art cooling device shown in Fig. 6 are denoted by the same reference numerals, and the description thereof will be omitted.

### First embodiment

Fig. 1 is a sectional view showing a cooling device for electric components installed in a casing according to the first embodiment, and Fig. 2 is a fragmentary plan sectional view of the same.

An air-tightly sealed casing 5 is mounted on the undersurface 6 of a floor of a train through an attachment 60.

One side wall of the casing 5 has an opening 50, and is mounted with an openable/closable cover 51 through an upper hinge 53 to open or close the opening 50. The cover 51 is structured to be locked by a lock means (not shown) when the opening 50 is closed.

The other side wall 54 of the casing 5 has a window hole 55, which is air-tightly closed by a thick heat absorbing block 2 mounted on the outside of the side wall 54.

A plurality of heat-generating electric components 4 serving as semiconductor modules are mounted through screws (not shown) on the surface of the heat absorbing block 2 such that the electric components are faced to the inside of the casing 5.

Heating sections 10 of vertically-arranged U-shaped heat pipes 1 are substantially horizontally pierced through the heat absorbing block 2 and held thereto (held in the embedded state). Thus, when the travelling structure such as a train travels horizontally in the advance direction, the heating sections 10 of the heat pipes 1 are held horizontally.

Each U-shaped heat pipe 1 has a substantially horizontal lower portion which forms the heating section 10. Both ends extending from the heating section 10 of each heat pipe 1 form heat radiative sections 11 which are inclined upwards such that the heat radiative sections are positioned higher than the heating sections. A large number of plate fins 3 are mounted on the heat radiative sections 11 at a certain pitch such that the plate fins extend substantially parallel to the heating sections 10.

According to this embodiment, since a train as one of the travelling structures travels in the direction indicated by an arrow b in Fig. 2, the fins 3 extend along an air current produced in consequence of travelling of the train.

A cylindrical cover 8 for protecting the fins 3 is mounted on the side surface of the casing 5 on the side provided with the heat absorbing block 2 such that the cover 8 extends along an air current produced in consequence of travelling of the train. Support plates 3a, 3a for supporting the heat pipes 1 for the purpose of reinforcement are mounted on the inside of the cover 8. The support plates 3a also serve as heat radiation plates.

In this embodiment, the heat pipes 1 are made of a metal material having high heat conductivity such as aluminum or aluminum alloy and copper or copper alloy.

The radiation fins 3, the heat absorbing block 2 and the support plates 3a are also made of a metal material similar to that of the heat pipes 1.

Instead of the U-shaped heat pipes 1, use may be made of generally looped heat pipes each structured such that the ends of the heat radiative sections 11, 11 are communicated with each other as one body, as shown by dotted lines 12 in Fig. 2.

When the looped heat pipes 1 are used, the heat conduction characteristics or the heat transportation characteristics of the heat pipes 1 are further enhanced.

According to the cooling device in the first embodiment, heat generated by the electric components 4 and heat generated in the casing 5 by other components (i.e., a snubber resistance 40, a snubber capacitor 41 and a gate amplifier 42) or the like are conducted to the heating section 10 of each heat pipe 1 through the heat absorbing block 2, then transported to the heat radiative section 11 due to a phase change of a working fluid enclosed in the heating section, and consequently radiated to the outside through the radiation fins 3.

Since the radiation fins 3 extend in the travel direction of the travelling structure, sufficient ventilation is attained in portions of the fins 3, and the heat radiation effect is improved more highly than that in a case where the fins 3 extend to be opposite to the travel direction of the travelling structure.

The heat absorbing block 2 mounted with the electric components 4 constitutes a part of the side wall 54 of the casing 5. Thus, since the heat absorbing block 2 is not largely projected into the casing 5 together with the heating sections 10, the spatial utility factor in the casing 5 is further improved.

Accordingly, more electric components are able to be mounted on the inside of the casing 5, and besides, the size of the casing 5 is able to be made smaller.

Since the heat absorbing block 2 constitutes a part of the vertical side wall 54 of the casing 5, any partition plate is not needed, and any heat pipes 1 are not pierced through the side wall of the casing 5. As a result, the casing 5 is structured more firmly.

Further, according to this embodiment, when the cover 51 is opened for the inspection or maintenance of various components installed in the casing 5, not only the electric components 4 positioned on the opposite surface (on the front) but also other components such as the snubber resistance 40, the snubber capacitor 41 and the gate amplifier 42 are fully observed, and therefore, the workability in case of performing the inspection and maintenance is remarkably enhanced.

The U-shaped heat pipes 1 each having the substantially lower portion which forms the heating section 10 or the looped heat pipes 1 each having one substantially horizontal side which forms the heating section 10 are applied to the cooling device in the first embodiment.

Therefore, the cooling device in the first embodiment is superior in heat exchange effectiveness and heat radiation effects to the cooling device which employs, for instance, substantially L-shaped heat pipes each having one horizontal side which forms the heating section.

For instance, when one horizontal side of each L-shaped heat pipe is formed as the heating section, a heat absorbing block 2 similar to that of the first embodiment is mounted on the heating section, and several electric components are mounted on the heat absorbing block 2, the following defects are conceivable in comparison with the case of the first embodiment.

When a travelling structure such as a vehicle travels in an inclined position along the travel direction, the evaporative capability of the heating sections in the cooling device employing the L-shaped heat pipes is largely unbalanced depending on the direction of inclination of the travelling structure, and as a result, there is a possibility that an cooling effect on part of the electric components is largely reduced.

On the other hand, when the cooling device employs the looped or U-shaped heat pipes 1 like the first embodiment, the unbalance evaporative capability of the heating sections due to the inclination is relatively reduced. Further, when each heat pipe 1 takes the looped or U-like shape, heat radiative sections 11 each having a large capacity are formed in a relatively narrow space, and as a result, the cooling capability is relatively increased more highly also in that respect.

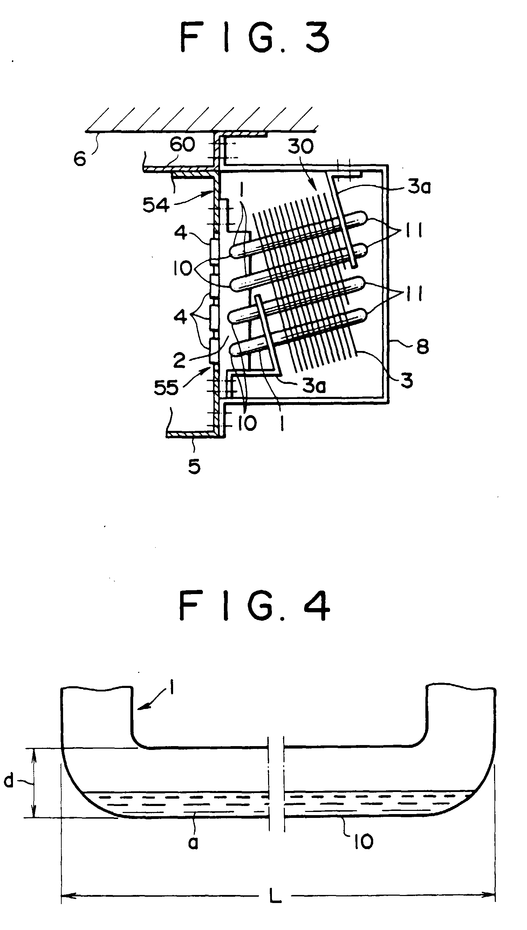

According to the cooling device in the first embodiment, the heating section 10 of each heat pipe 1 has an inner diameter d of about 15 mm and a length L of about 300 mm as shown in Fig. 4. A working fluid a in a quantity of 30 to 40 % of the volume of the heating section 10 is enclosed in the heating section 10.

The working fluid a is preferably enclosed in the heating section 10 such that the bottom surface of the heating section 10 is wholly covered with the working fluid a in order to efficiently perform the heat exchanqe in each heat pipe 1. For instance, when the travelling structure is supposed to be a train, the train travels in a line other than a line of a mountainous region at a maximum inclination of about 4° to the travel direction. However, when the size of the heating section 10 and the quantity of the working fluid a enclosed in the heating section 10 agree with the requirement defined by the embodiment, the substantially whole bottom surface of the heating section 10 is covered with the working fluid a, even if the traveling structure travels at an inclination of about 4° to the travel direction (i.e., to the length direction of the heating section 10).

Therefore, when the travelling structure is supposed to be the train in the first embodiment, the heat exchange effectiveness of the heat pipes 1 is not reduced as long as the travelling structure travels in a usual line.

### Second embodiment

Fig. 3 is a fragmentary sectional view showing a cooling device in a second embodiment of the present invention.

According to the cooling device in the second embodiment, radiation fins 3 of the same size are mounted on the center portion of a heat radiative section 11 of each heat pipe 1, and an appropriate number of radiation fins 30 smaller in size than those mounted on the center portion are mounted on the leading end of a heat radiative section 11 of each upper heat pipe 1.

With the above structure, the dispersion of heat of the electric components 4 due to the natural convection of air in the casing 5 is reduced. Namely, the temperature of an upper space in the casing 5 becomes higher than that of a lower space due to the convection of air in the casing 5, so that the temperature of the electric components 4 mounted on the upper part of the heat absorbing block 2 rises higher than that of the electric components 4 mounted on the lower part thereof. Thus, by mounting the appropriate number of small-sized fins 30 on the heat radiative section 11 of each upper heat pipe 1, the dispersion of temperature of the electric components 4 is made smaller.

The other constitution, operation and effects of the cooling device in the second embodiment are substantially similar to those of the cooling device in the first embodiment, and the description thereof will be omitted.

### Third embodiment

Fig. 5 is a fragmentary plan sectional view showing a cooling device in a third embodiment of the present invention.

The cooling device in the third embodiment comprises a heat absorbing block 2a having an appropriate number of holes 2b each positioned so as to extend in the substantially horizontal direction when being in use. Heat-generating electric components 4 are mounted on one surface of the heat absorbing block 2a.

Both ends of each hole 2b of the heat absorbing block 2a are air-tightly communicated with one end of pipes 1a in the bent state. Although not shown, a large number of radiation fins are mounted on each pipe 1a substantially parallel to the holes 2b, similarly to the radiation fins 3 mounted on the heat radiative sections 11 shown in Fig. 1.

The other ends of the pipes 1a are sealed as shown by solid lines in Fig. 5 or communicated with each other as one body as shown by two-dotted lines 1b in Fig. 5.

An appropriate quantity of refrigerant (not shown) is enclosed in an air-tightly sealed system composed of the holes 2b and each pipe 1a, and therefore, the air-tightly sealed system constitutes a heat pipe as a whole.

The heat absorbing block 2a is mounted on the side wall of the casing 5 with the electric components 4 faced to the inside of the casing 5, substantially similarly to the heat absorbing block 2 in the first embodiment shown in Fig. 1, and constitutes a part of the side wall of the casing 5.

According to the cooling device in the third embodiment, the heat absorbing block 2a forms the heating section of each heat pipe, and each pipe 1a forms the heat radiative section of a heat pipe. Thus, heat generated by the electric components 4 is absorbed by the refrigerant enclosed in the holes 2b of the heat absorbing block 2a, then transferred toward the pipes 1a due to the evaporation of the refrigerant, and consequently radiated to the outside.

Since the heat absorbing block 2a of the cooling device in the third embodiment forms the heating section of the air-tightly sealed system (i.e., a heat pipe) as it is, any problem does not arise as to contact thermal resistance between the heating section 10 and the heat absorbing block 2, in comparison with a structure such that the heating section of each heat pipe 1 is pierced through the heat absorbing block 2 and held thereto, like the cooling device in the first embodiment shown in Fig. 1. Thus, the heat exchange capability of the heating portion of the air-tightly sealed system (i.e., the heat pipe) is enhanced more highly.

The other constitution, operation and effects of the cooling device in the third embodiment are substantially similar to those of the cooling device in the first embodiment, and the description thereof will be omitted.

### Other embodiments

Each looped heat pipe 1 in the cooling device in the first and second embodiments has two inclined heat radiative sections 11 extending from both ends of the heating section 10. Otherwise, each heat pipe may have three or more heat radiative sections 11 formed at predetermined intervals so as to extend from the heating section 10 in the same direction.

In the first and second embodiments, each U-shaped or looped heat pipe 1 is held by the heat absorbing block 2 such that only a straight portion of the heating section 10 is embedded in the heat absorbing block 2. Otherwise, a portion including the bent portions on both ends of the heating section may be embedded in the heat absorbing block 2.

The radiation fins 3 mounted on the heat radiative sections 11 are not limited only to the above structure, and honeycomb-shaped or other structures may be applied to the radiation fins.

## Claims

1. A cooling device for at least one electric component installed in a casing of a travelling structure, comprising :
at least one looped heat pipe (1) having one substantially horizontal side which forms a heating section (10), or at least one substantially U-shaped heat pipe (1) having a substantially horizontal lower portion which forms a heating section (10);
a heat absorbing block (2) mounted on the heating section (10) of the or each heat pipe (1) and mounted with at least-one heat-generating electric component (4); and
at least one radiation fin (3) mounted on the heat radiative section (11) of the or each heat pipe (1) substantially parallel to said heating section (10);
wherein said heat absorbing block is mounted on the side wall of a casing (5) with said electric component(s) (4) faced to the inside of the casing (5), and constitutes a part of the side wall of said casing (5).

2. A cooling device according to claim 1, wherein the heating section (10) of the or each heat pipe (1) is embedded in said heat absorbing block (2).

3. A cooling device for at least one electric component installed in a casing of a travelling structure, comprising :
a heat absorbing block (2a) having at least one hole (2b) positioned so as to extend in the substantially horizontal direction when being in use, and mounted with at least one heat-generating electric component (4);
pipes (1a) respectively having one end air-tightly communicated with both ends of the or each hole (2b); and
at least one radiation fin (3) mounted on the or each pipe (1a);
wherein the other ends of said respective pipes (1a) are communicated with each other as one body or air-tightly sealed;
an appropriate quantity of refrigerant is enclosed in the or each air-tightly sealed system composed of one said hole (2b) and the respective pipes (1a); and
said heat absorbing block (2a) is mounted on the side wall of a casing (5) with said electric component(s) (4) faced to the inside of the casing (5), and constitutes a part of the side wall of said casing (5).

## Patentansprüche

1. Kühlungsvorrichtung für wenigstens eine elektrische Baugruppe, die in einem Gehäuse einer fahrbaren Struktur installiert ist, mit:
wenigstens einer zu einer Schleife geschlossenen Heatpipe (1), die eine im wesentlichen waagerechte, einen Heizabschnitt (10) bildende Seite hat, oder wenigstens einer im wesentlichen U-förmgen Heatpipe (1), die einen im wesentlichen waagerechten, einen Heizabschnitt (10) bildenden unteren Teil hat,
einem wärmeabsorbierenden Block (2), der auf dem Heizabschnitt (10) der oder jeder Heatpipe (1) montiert und mit wenigstens einer wärmerzeugenden elektrischen Baugruppe bestückt ist, und
wenigstens einer Radiatorrippe (3), die auf dem im wesentlichen parallel zu dem Heizabschnitt (10) verlaufenden wärmeabstrahlenden Abschnitt (11) der oder jeder Heatpipe (1) montiert ist.
wobei der wärmeabsorbierende Block so an der Seitenwand eines Gehäuses (5) montiert ist, daß die elektrische(n) Baugruppe(n) (4) der Innenseite des Gehäuses zugewandt ist, und einen Teil der Seitenwand des Gehäuses (6) bildet.

2. Kühlungsvorrichtung nach Anspruch 1, bei der der Heizabschnitt (10) der oder Jeder Heatpipe in den wärmeabsorbierenden Block (2) eingebettet ist.

3. Kühlungsvorrichtung für wenigstens eine elektrische Baugruppe, die in einem Gehäuse einer fahrbaren Struktur installiert ist, mit:
einem wärmeabsorbierenden Block (2a), der wenigstens ein Loch (2b) hat, daß so positioniert ist, daß es im Gebrauch in der im wesentlichen waagerechten Richtung verläuft, und der mit wenigstens einer wärmeezeugenden elektrischen Baugruppe (4) bestückt ist,
Rohren (1a), bei denen jeweils ein Ende luftdicht mit beiden Enden des oder jedes Loches (2b) verbunden ist, und
wenigstens einer Radiatorrippe (3). die auf dem oder jedem Rohr (1a) montiert ist,
wobei die äußeren Enden der jeweiligen Rohre (1a) in einem Stück oder luftdicht versiegelt miteinander verbunden sind,
eine geeignete Menge eines Kühlmittels in dem oder jedem luftdicht abgeschlossenen System eingeschlossen ist, daß durch das Loch (2b) und die jeweiligen Rohre (1a) gebildet wird, und
der wärmeabsorbierende Block (2a) so an der Seitenwand eines Gehäuses (5) montiert ist, daß die elektrische(n) Baugruppe(n) (4) der Innenseite des Gehäuses zugewandt ist, und einen Teil der Seitenwand des Gehäuses (6) bildet.

## Revendications

1. Dispositif de refroidissement pour au moins un composant électrique disposé dans un boîtier d'une structure de transport, comprenant :
au moins un tuyau chauffant (1) en boucle ayant un côté sensiblement horizontal qui forme une section chauffante (10), ou au moins un tuyau chauffant (1) sensiblement en forme de U ayant une partie inférieure sensiblement horizontale qui forme une section chauffante (10),
un bloc d'absorption de chaleur (2) monté sur la section chauffante (10) du ou de chaque tuyau chauffant (1) et monté avec au moins un composant électrique (4) produisant de la chaleur et
au moins une ailette de rayonnement (3) montée sur la section (11) rayonnant de la chaleur du ou de chaque tuyau chauffant (1) sensiblement parallèle à ladite section chauffante (10),
dans lequel le bloc d'absorption de chaleur est monté sur la paroi latérale d'un boîtier (5) avec le ou les composants électriques (4) orienté(s) vers l'intérieur du boîtier (5) et constitue une partie de la paroi latérale du boîtier (5).

2. Dispositif de refroidissement suivant la revendication 1, dans lequel la section chauffante (10) du ou de chaque tuyau chauffant (1) est noyée dans le bloc d'absorption de chaleur (2).

3. Dispositif de refroidissement pour au moins un composant électrique disposé dans un boîtier d'une structure de transport, comprenant :
un bloc d'absorption de chaleur (2a) ayant au moins un passage (2b) disposé de façon à s'étendre suivant la direction sensiblement horizontale en cours d'utilisation et monté avec au moins un composant électrique (4) produisant de la chaleur,
des tuyaux (1a) ayant respectivement une extrémité communiquant d'une manière étanche à l'air avec les deux extrémités du ou de chaque passage (2b) et
au moins une ailette de rayonnement (3) montée sur le tuyau ou chaque tuyau (1a),
dans lequel les autres extrémités des tuyaux (1a) respectifs communiquent l'une avec l'autre en formant un seul corps ou en étant scellées d'une manière étanche à l'air,
une quantité appropriée de réfrigérant est enfermée dans le ou chaque système scellé d'une manière étanche à l'air composé d'un passage (2b) et des tuyaux (1a) respectifs et
le bloc d'absorption de chaleur (2a) est monté sur la paroi latérale d'un boîtier (5) avec le ou les composants électriques (4) orienté(s) vers l'intérieur du boîtier (5) et constitue une partie de la paroi latérale du boîtier (5).
